# EUROPEAN PATENT SPECIFICATION

(11) **EP 3 451 374 B1**
(45) Date of publication and mention of the grant of the patent: **15.03.2023**
(21) Application number: 17001474.0
(22) Date of filing: 01.09.2017
(51) Int. Cl.: H01L 23/31, G01D 11/24

(54) **SEMICONDUCTOR DEVICE PACKAGE**
HALBLEITERBAUELEMENTGEHÄUSE
BOÎTIER DE DISPOSITIF À SEMI-CONDUCTEUR

(43) Date of publication of application: 06.03.2019
(73) Proprietor: TDK-Micronas GmbH, 79108 Freiburg (DE)
(72) Inventor: Camillo, Pilla, 79102 Freiburg (DE)
(74) Representative: Koch Müller Patentanwaltsgesellschaft mbH

(56) References cited:
- GB-A- 1 261 378
- JP-A- S6 315 448
- JP-A- H04 179 256
- JP-A- H11 289 113
- US-A- 5 219 795
- US-A1- 2015 266 728

## Description

The invention relates to a semiconductor device package.

A semiconductor device package is known from US 9,355,968 B2. An outer molding compound, i.e., a potting compound, surrounds a device. On the top side of the device, a plate made of silicon is glued in the central part of the surface to reduce the pressure on the surface of the device. Device packages comprising at least two package parts are known from JP H11 289113 A, JP H04 179256 A, GB 1 261 378 A, US 5,219,795 A, US 2015/0266728 A1 as well as JP S63 15448 A.

Further semiconductor device packages are known from US 5,165,956, US 5,275,841, and from C.P. Wong, Recent Advances in Plastic Packaging of Flip-Chip and Multichip Modules (MCM) of Microelectronics, IEEE Transactions on Components and Packaging Technology, Vol. 22, No. 1, March 1999, pp. 21-25. In this case, a device arranged on a ceramic substrate is wholly or partially encapsulated with a silicone gel for increasing the shock resistance and for reducing the stress input due to temperature changes between the substrate and the device. The silicone gel is encapsulated above by a potting compound, i.e., molding compound, whereas the substrate is formed on the underside.

On this background, it is therefore an object of the invention to provide a device that refines the prior art.

The object is achieved by a semiconductor device package comprising a device disposed in a package, wherein the device has at least two electrical feed-through connections which pass through the package, the package comprises a first package part and a second package part, and the first package part surrounds the second package part completely or almost completely, except for the feedthrough of the electrical connections, and the first package part comprises a different material than the second package part, and the second package part comprises a filling material, and the filling material surrounds the device, the semiconductor device is disposed on a substrate and the semiconductor device and the substrate are enclosed by the filling material, the substrate comprises a metallic lead strip or consists of a metallic lead strip and the three main stresses of the stress tensor, which stresses act on the device along the main stress directions formed orthogonally to one another are of the same magnitude due to the filling material, so that there is a hydrostatic stress state for the device characterized in that the package comprises a third package part and the second package part completely surrounds the third package part, and the first package part and the third package part have the same materials, wherein the material of the first and third package part is a molding or potting compound.

Preferred embodiments of the invention are set out in the appended dependent claims.

It should be noted that the device can also be designed as a plurality of devices, which are arranged side by side or one above the other, in particular dies with integrated circuits.

It is understood that the first package part always represents the outer package part and is substantially stronger or harder than the second package part; i.e., the first package part has a greater strength or hardness.

One advantage is that with the multi-shell structure, anisotropic stress on the device can be avoided in a simple and cost-effective manner, or can at least be reduced as far as possible. In particular, if after the encapsulation, also called molding, the encapsulated devices, also called chips, are incorporated into further packages or are supplied with additional potting compounds and/or there are additional shear stresses because of environmental influences, only a hydrostatic pressure acts on the device due to the particular filling material. A drift of the parameters, in particular, the electrical parameters due to shear stresses is suppressed.

In other words, the force on the device is equal from all sides; i.e., shear stresses are suppressed. In particular for sensors or electronic circuits, e.g., bandgap circuits are substantially more long-term stable as a result.

A further advantage is that the molding process, i.e., the effects of the molding process, is substantially less sensitive at least with respect to an anisotropic compressive stress input. The potting process is generally more reliable.

A further advantage is that an introduction of shear stresses is suppressed by the filler material during fixing or soldering or connecting of the electrical feed-throughs, which are also referred to as pins.

It should be noted that the two-shell structure can be carried out cost-effectively by means of a double encapsulation process.

In a refinement, the filling material comprises a gel and/or a silicone or consists of a gel and/or a silicone.

In a further refinement, the filling material has a low Young modulus with a value smaller than 5GPa.

The device is disposed on a substrate. The device and the substrate are enclosed by the filling material. It is understood that the electrical connections are arranged on the substrate at least non-positively.

In a further refinement, the device comprises an integrated circuit and/or passive components. Preferably, the device is formed as a silicon die, the silicon die comprising a monolithically integrated circuit.

The substrate comprises a metallic lead strip, also called a lead frame, or consists of a metallic lead strip. Preferably passive components are also arranged on the substrate next to the device or on the device.

In a refinement, the device comprises a magnetic field sensor and/or a temperature sensor and/or a stress sensor, in particular a pressure sensor. Preferably, there are a plurality of sensors of one kind, for example, to detect the values of a physical quantity such as, in particular, stress or a magnetic field in the different spatial directions. Preferably, the magnetic field sensors and, in particular, the Hall sensor(s) is (are) formed monolithically together with an integrated circuit on a silicon substrate. In this case, the integrated circuit preferably comprises a control and evaluation circuit for the magnetic field sensor(s).

In one embodiment, the device comprises one or more Hall sensors or one or more Hall plates. Preferably, the device comprises different types of magnetic field sensors.

According to the invention, the package comprises a third package part, wherein the second package part completely surrounds the third package part, i.e., except for the electrical feed-throughs. It is understood that the third package part has a different material than the second package part. Preferably, the material of the third package part is stronger or harder than the filler material. The first package part and the third package part have the same materials.

According to the invention, the filling material surrounds the device completely, i.e., except for the feed-throughs.

In a further refinement, the first package part surrounds the second package part completely, i.e., except for the feed-throughs, or the first package part surrounds the second package part, except for the immediate vicinity of the feed-through. Preferably, the immediate vicinity comprises an area between 0.1 mm and 5 mm, most preferably a maximum of 2 mm.

In one embodiment, the first package part and/or the third package part comprise a potting compound or consist of a potting compound.

In one embodiment, the hydrostatic stress state is formed as pressure.

The invention will be described in greater detail herein below with reference to the drawings. In this regard, similar parts are labeled with identical designations. The illustrated embodiments are highly schematized; i.e., the distances and the lateral and vertical extents are not to scale and, if not otherwise indicated, also do not have any derivable geometric relationships to one another. In the drawing:
FIG. 1 shows a perspective sketch of an embodiment not according to the invention of a semiconductor device package;
FIG. 2 shows a perspective sketch of an embodiment according to the invention of a semiconductor device package.

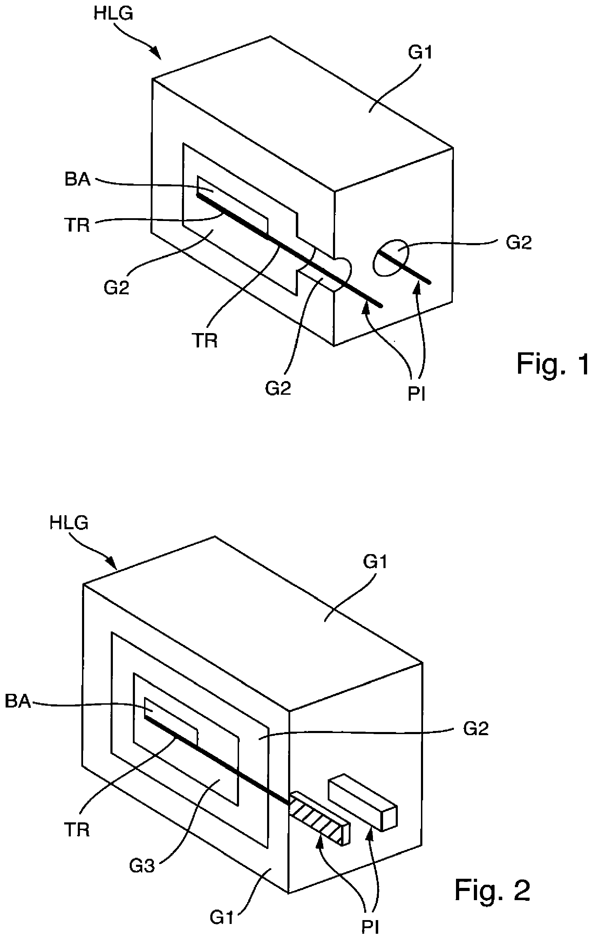

The illustration in FIG. 1 is a perspective sketch of an embodiment not according to the invention of a semiconductor device package HLG with a first outer package part G1 and a second package part G2. It is understood that the sketch shows a sectional view; in other words, for reasons of clarity, the other half of the package is not shown.

First package part G1 completely encloses second package part G2 except for the immediate vicinity of the electrical connections.

First package part G1 consists of a different material than second package part G2. First package part G1 consists of a molding compound. Second package part G2 consists of or preferably comprises a material with a Young modulus < 5GPa or a silicone gel as a filler material.

A device BA is arranged within second package part G2 as an integrated circult with a Hall sensor on a substrate TR designed as a lead frame. Device BA and substrate TR are materially enclosed by the silicone gel.

The two electrical connections PI designed as pins penetrate the two package parts G1 and G2. In the present case, the second package part encloses the pins except for one end part. In other words, in the present case the pins are not directly enclosed by first package part G1; i.e., they do not have a material contact area with the first package part.

In an embodiment, which is not shown, the pins are directly enclosed by first package part G1.

By means of second package part G2, stress acting through first package part G1 is distributed along the main stress directions, formed orthogonally to one another, of the stress tensor and is of the same magnitude, so that a hydrostatic stress state results for device BA.

The illustration In FIG. 2 shows a perspective sketch of a an embodiment according to the invention of a semiconductor device package HLG. Only the differences from the illustration in FIG. 1 will be explained below.

In this case, device BA and substrate TR are completely enclosed materially by a material of a third package part G3 except for the feed-throughs. The silicone gel of second package part G2 completely surrounds third innermost package part G3 except for the feed-throughs. Second package part G2 is enclosed completely by first package part G1 except for the feed-throughs. In this case, first package part G1, therefore the molding compound, also encloses the feed-throughs completely in one section.

## Claims

1. A semiconductor device package (HLG), comprising a device (BA) disposed in a package, wherein
- the device (BA) has at least two electrical feed-through connections (PI) which pass through the package,
- the package comprises a first package part (G1) and a second package part (G2), and the first package part (G1) surrounds the second package part (G2) completely or almost completely, except for the feedthrough of the electrical connections (PI), and the first package part (G1) comprises a different material than the second package part (G2), and the second package part (G2) comprises a filling material, and the filling material surrounds the device (BA),
- the semiconductor device (BA) is disposed on a substrate (TR) and the semiconductor device (BA) and the substrate (TR) are enclosed by the filling material,
- the substrate (TR) comprises a metallic lead strip or consists of a metallic lead strip and
- the three main stresses of the stress tensor, which stresses act on the device (BA) along the main stress directions formed orthogonally to one another are of the same magnitude due to the filling material, so that there is a hydrostatic stress state for the device (BA)
**characterized in that**
- the package (HLG) comprises a third package part (G3) and the second package part (G2) completely surrounds the third package part (G3), and
- the first package part (G1) and the third package part (G3) have the same materials, wherein the material of the first and third package part is a molding or potting compound.

2. The semiconductor device package (HLG) according to claim 1, **characterized in that** the filling material comprises a gel and/or a silicone or consists of a gel and/or a silicone.

3. The semiconductor device package (HLG) according to one of claims 1 or 2, **characterized in that** the device comprises an integrated circuit.

4. The semiconductor device package (HLG) according to one of claims 1 to 3, **characterized in that** the device (BA) comprises a magnetic field sensor.

5. The semiconductor device package (HLG) according to one of claims 1 to 4, **characterized in that** the device (BA) comprises one or more Hall sensors.

6. The semiconductor device package (HLG) according to one of claims 1 to 5, **characterized in that** the filling material has a Young's modulus smaller than 5GPa.

7. The semiconductor device package (HLG) according to one of claims 1 to 6, **characterized in that** the first package part surrounds the second package part except for the immediate vicinity of the feed-through, wherein the immediate vicinity comprises an area between 0.1 mm and 5 mm.

8. The semiconductor device package (HLG) according to claim 7, **characterized in that** the immediate vicinity comprises a maximum of 2 mm.

9. The semiconductor device package (HLG) according to one of claims 1 to 8, **characterized in that** the device comprises different types of magnetic field sensors.

10. The semiconductor device package (HLG) according to one of claims 1 to 9, **characterized in that** the device comprises passive components.

11. The semiconductor device package (HLG) according to one of claims 1 to 10, **characterized in that** the device is formed as a silicon die and the silicon die comprises a monolithically integrated circuit.

12. The semiconductor device package (HLG) according to one of claims 1 to 11, **characterized in that** the material of the second package is silicone gel, and the device (BA) and substrate (TR) are completely enclosed materially by the material of a third package part (G3) except for the feed-throughs.

## Patentansprüche

1. Halbleiterbauelementgehäuse (HLG), aufweisend
- ein in einem Gehäuse angeordnetes Bauelement (BA), wobei das Bauelement (BA) wenigstens zwei das Gehäuse durchgreifende elektrische Anschlüsse (PI) aufweist,
- das Gehäuse einen ersten Gehäuseteil (G1) und einem zweiten Gehäuseteil (G2) aufweist und der erste Gehäuseteil (G1) den zweiten Gehäuseteil (G2) bis auf die Durchführung der elektrischen Anschlüsse vollständig (PI) oder nahezu vollständig umschließt und der erste Gehäuseteil (G1) ein anderes Material als der zweite Gehäuseteil (G2) umfasst und der zweite Gehäuseteil (G2) ein Füllmaterial umfasst und das Füllmaterial das Bauelement (BA) umschließt,
- das Halbleiterbauelement (BA) auf einem Träger (TR) angeordnet ist und das Halbleiterbauelement (BA) und das Träger (TR) von dem Füllmaterial umschlossen sind
- der Träger (TR) einen metallischen Trägerstreifen umfasst oder aus einem metallischen Trägerstreifen besteht, und
mittels des Füllmaterials die drei auf das Bauelement (BA) entlang den orthogonal zueinander ausgebildeten Hauptspannungsrichtungen einwirkenden Hauptspannungen des Spannungstensors gleich groß sind, so dass für das Bauelement (BA) ein hydrostatischer Spannungszustand vorliegt **dadurch gekennzeichnet, dass**
- das Gehäuse einen dritten Gehäuseteil (G3) umfasst und der zweite Gehäuseteil (G2) den dritten Gehäuseteil (G3) vollständig umschließt, und
- der erste Gehäuseteil (G1) und der dritte Gehäuseteil (G3) die gleichen Materialien aufweisen, wobei das Material des ersten Gehäuseteils (G1) und des ersten und des dritten Gehäuseteils (G3) jeweils als a Guss oder Vergussmasse besteht..

2. Halbleiterbauelementgehäuse (HLG) nach Anspruch 1, **dadurch gekennzeichnet, dass** das Füllmaterial ein Gel und / oder ein Silikon umfasst oder aus einem Gel und / oder einem Silikon besteht.

3. Halbleiterbauelementgehäuse (HLG) nach Anspruch 1 oder Anspruch 2, **dadurch gekennzeichnet, dass** das Bauelement eine integrierte Schaltung umfasst.

4. Halbleiterbauelementgehäuse (HLG) nach einem der Ansprüche 1 bis 3, **dadurch gekennzeichnet, dass** das Bauelement (BA) einen Magnetfeldsensor umfasst.

5. Halbleiterbauelementgehäuse (HLG) nach einem der Ansprüche 1 bis 4, **dadurch gekennzeichnet, dass** das Bauelement (BA) einen oder mehrere Hallsensoren umfasst.

6. Halbleiterbauelementgehäuse (HLG) nach einem der Ansprüche 1 bis 5, **dadurch gekennzeichnet, dass** das Füllmaterial einen Elastizitätsmodul von weniger als 5 GPa aufweist.

7. Halbleiterbauelementgehäuse (HLG) nach einem der Ansprüche 1 bis 6, **dadurch gekennzeichnet, dass** der erste Gehäuseteil den zweiten Gehäuseteil mit Ausnahme der unmittelbaren Umgebung der Durchführung umgibt, wobei die unmittelbare Umgebung einen Bereich zwischen 0,1 mm und 5 mm umfasst.

8. Halbleiterbauelementgehäuse (HLG) nach Anspruch 7, **dadurch gekennzeichnet, dass** die unmittelbare Umgebung maximal 2 mm umfasst.

9. Halbleiterbauelementpaket (HLG) nach einem der Ansprüche 1 bis 8, **dadurch gekennzeichnet, dass** das Bauelement verschiedene Arten von Magnetfeldsensoren umfasst.

10. Halbleiterbauelementgehäuse (HLG) nach einem der Ansprüche 1 bis 9, **dadurch gekennzeichnet, dass** das Bauelement passive Bauelemente umfasst.

11. Halbleiterbauelementgehäuse (HLG) nach einem der Ansprüche 1 bis 10, **dadurch gekennzeichnet, dass** das Bauelement als Siliziumchip ausgebildet ist und der Siliziumchip eine monolithisch integrierte Schaltung umfasst.

12. Halbleiterbauelement-Gehäuse (HLG) nach einem der Ansprüche 1 bis 11, **dadurch gekennzeichnet, dass** das Material des zweiten Gehäuses Silikongel ist und das Bauelement (BA) und das Substrat (TR) mit Ausnahme der Durchführungen vollständig vom Material eines dritten Gehäuseteils (G3) umschlossen sind.

## Revendications

1. Boîtier de dispositif semi-conducteur (HLG) comprenant un dispositif (BA) disposé dans un boîtier,
- le dispositif (BA) ayant au moins deux connexions électriques traversantes (PI) qui traversent le boîtier,
- le boîtier comprenant un premier élément de boîtier (G1) et un deuxième élément de boîtier (G2), lequel premier élément de boîtier (G1) entoure complètement ou presque complètement le deuxième élément de boîtier (G2), hormis la traversée des connexions électriques (PI), et lequel premier élément de boîtier (G1) comprend un matériau différent du deuxième élément de boîtier (G2), lequel deuxième élément de boîtier (G2) comprend un matériau de remplissage, lequel matériau de remplissage entoure le dispositif (BA),
- le dispositif semi-conducteur (BA) étant disposé sur un substrat (TR) et le dispositif semi-conducteur (BA) et le substrat (TR) étant enfermés par le matériau de remplissage,
- le substrat (TR) comprenant une bande conductrice métallique ou étant constitué d'une bande conductrice métallique et
- les trois contraintes principales du tenseur de contrainte, lesquelles contraintes agissent sur le dispositif (BA) le long des directions de contraintes principales formées perpendiculairement les unes aux autres, étant de même magnitude du fait du matériau de remplissage, de sorte qu'il existe un état de contrainte hydrostatique pour le dispositif (BA),
**caractérisé en ce que**
- ce boîtier (HLG) comprend un troisième élément de boîtier (G3) et le deuxième élément de boîtier (G2) entoure complètement le troisième élément de boîtier (G3), et que
- le premier élément de boîtier (G1) et le troisième élément de boîtier (G3) ont les mêmes matériaux, le matériau du premier et du troisième élément de boîtier étant une masse de moulage ou d'enrobage.

2. Boîtier de dispositif semi-conducteur (HLG) selon la revendication 1, **caractérisé en ce que** le matériau de remplissage comprend un gel et/ou un silicone ou est constitué d'un gel et/ou d'un silicone.

3. Boîtier de dispositif semi-conducteur (HLG) selon une des revendications 1 ou 2, **caractérisé en ce que** le dispositif comprend un circuit intégré.

4. Boîtier de dispositif semi-conducteur (HLG) selon une des revendications 1 à 3, **caractérisé en ce que** le dispositif (BA) comprend un capteur de champ magnétique.

5. Boîtier de dispositif semi-conducteur (HLG) selon une des revendications 1 à 4, **caractérisé en ce que** le dispositif (BA) comprend un ou plusieurs capteurs à effet Hall.

6. Boîtier de dispositif semi-conducteur (HLG) selon une des revendications 1 à 5, **caractérisé en ce que** le matériau de remplissage a un module de Young inférieur à 5 GPa.

7. Boîtier de dispositif semi-conducteur (HLG) selon une des revendications 1 à 6, **caractérisé en ce que** le premier élément de boîtier entoure le deuxième élément de boîtier sauf à proximité immédiate de la traversée, la proximité immédiate comprenant une zone de 0,1 mm à 5 mm.

8. Boîtier de dispositif semi-conducteur (HLG) selon la revendication 7, **caractérisé en ce que** la proximité immédiate comprend un maximum de 2 mm.

9. Boîtier de dispositif semi-conducteur (HLG) selon une des revendications 1 à 8, **caractérisé en ce que** le dispositif comprend différents types de capteurs de champ magnétique.

10. Boîtier de dispositif semi-conducteur (HLG) selon une des revendications 1 à 9, **caractérisé en ce que** le dispositif comprend des composants passifs.

11. Boîtier de dispositif semi-conducteur (HLG) selon une des revendications 1 à 10, **caractérisé en ce que** le dispositif est formé comme une puce de silicium et que cette puce de silicium comprend un circuit intégré monolithique.

12. Boîtier de dispositif semi-conducteur (HLG) selon une des revendications 1 à 11, **caractérisé en ce que** le matériau du deuxième boîtier est du gel de silicone et que le dispositif (BA) et le substrat (TR) sont complètement enfermés matériellement par le matériau d'un troisième élément de boîtier (G3) à l'exception des traversées.
